# EUROPEAN PATENT APPLICATION

(11) **EP 4 450 992 A1**
(43) Date of publication of application: **23.10.2024**
(21) Application number: 23168554.6
(22) Date of filing: 18.04.2023
(51) Int. Cl.: G01R 31/72, G01R 31/62, G01R 31/12

(54) **METHOD FOR MONITORING AN ELECTRICAL DEVICE COMPRISING AT LEAST ONE COIL FOR WINDING SHORT CIRCUITS, MONITORING DEVICE, USE AND ARRANGEMENT**

(71) Applicant: HSP Hochspannungsgeräte GmbH, 53842 Troisdorf (DE)
(72) Inventor: Pointner, Klaus, 4040 Linz (AT); Haiden, Martin, Linz (AT)
(74) Representative: Betten & Resch

(57) **Abstract**

The present invention relates to a method for monitoring an electrical device (2) comprising at least one coil (3), in particular a reactor, preferably an air core reactor, or a transformer, for winding short circuits (8), in which
- during operation of the electrical device (2) a magnetic field generated by the at least one coil (3) is continuously or at predetermined times measured with a magnetic field sensor (9),
- it is determined if an anomaly of the magnetic field, in particular an abnormal field intensity, is present, wherein a comparison of at least one value measured with the magnetic field sensor (9) and/or at least one value deduced therefrom with at least one reference value is carried out, and
- the presence of an anomaly of the magnetic field is used to identify an impending or occurred winding short circuit (8).

Furthermore, the invention relates to a monitoring device (4), the use of such and an arrangement (1).

## Description

The present invention relates to a method for monitoring an electrical device comprising at least one coil, in particular a reactor, preferably an air core reactor, or a transformer, for winding short circuits. Furthermore, the invention relates to a monitoring device, the use of such and an arrangement comprising an electrical device with at least one coil, in particular a reactor, preferably an air reactor, or a transformer, and at least one monitoring device.

Winding shorts can occur in electrical devices with at least one coil, such as electrical reactors, e.g. air core reactors or oil- or gas-insulated reactors, transformers or the like. A winding short circuit is a short circuit between the windings (turns) of a coil (also referred to as "winding turn-to-turn faults"). The windings of the coil(s) are usually separated by insulation. However, the insulation can be damaged and short circuits between windings can for example occur as a result of the damage.

A high risk is associated with winding short circuits. If they occur, they can lead to smoldering fires in the insulation and affected electrical devices, for example air core reactors, can partially or completely burn down. Such fires pose a high risk of destruction as well as a high risk of injuries for persons that may be present in the vicinity. They also pose an environmental risk.

If a visual inspection of electrical devices, in particular their coil(s) or insulation, is carried out, it is usually not easy to detect failures or beginning failures or they can only be detected at a rather late stage, i.e. when a smoldering or fire already occurs being accompanied by the development of smoke.

It is therefore an object of the present invention, to provide a method and a device which enable for a reliable and early detection of winding short circuits.

This object is solved by a method for monitoring an electrical device comprising at least one coil, in particular a reactor, preferably an air core reactor, or a transformer, for winding short circuits, in which
- during operation of the electrical device a magnetic field generated by the at least one coil is continuously or at predetermined times measured with a magnetic field sensor,
- it is determined if an anomaly of the magnetic field, in particular an abnormal field intensity, is present, wherein a comparison of at least one value measured with the magnetic field sensor and/or at least one value deduced therefrom with at least one reference value is carried out, and
- the presence of an anomaly of the magnetic field is used to identify an impending or occurred winding short circuit.

Furthermore, the object is solved by a monitoring device for monitoring an electrical device comprising at least one coil, in particular a reactor, preferably an air core reactor, or a transformer, for winding short circuits, comprising
- a magnetic field measuring unit comprising or consisting of at least one magnetic field sensor, in particular at least one preferably linear Hall sensor,
- a processing unit being connected to the magnetic field measuring unit and being able to receive and process data that has been acquired with the magnetic field measuring unit,
- a data transfer unit being connected to the processing unit and being embodied for wirelessly transmitting data,
- a power supply unit for electrical supply of the magnetic field measuring unit and the processing unit and the data transfer unit.

The monitoring device according to the invention has proven to be particularly suitable for carrying out the method according to the invention. Also, the inventive monitoring device requires comparatively few components and can be manufactured easily and cost-effectively.

Expediently, the processing unit is embodied and/or configured for determining if an anomaly is present at a magnetic field measured with the magnetic field measuring unit by comparing at least one value measured with the magnetic field sensor and/or at least one value deduced therefrom with at least one reference value preferably being stored in the processing unit.

The basic idea of the present invention in other words is to measure the magnetic field of the at least one coil of the electrical device and to detect anomalies. Due to magnetic field monitoring a very high sensitivity is obtained and winding short circuits can be detected quite reliably also at an early stage of developing faults. Preventive detection before the occurrence of major damage, like smoldering fires or the like, becomes possible.

At the same time, it is not necessary to compromise the insulation of the coil(s) for performing the inventive method for monitoring an electrical device for winding short circuits preferably by use of the inventive monitoring device. The magnetic field sensor or monitoring device just has to be positioned such that measuring the field of the coil(s) is possible.

If a magnetic field anomaly is detected, at least one signal, in particular warning signal, can be issued or emitted, preferably wirelessly. The inventive monitoring device can be embodied and/or configured accordingly. The receiver of such a signal may be a ground station preferably located at a distance from the electrical device. Such a ground station can be an IoT device.

A magnetic field anomaly due to which a winding short circuit is detected in the framework of the inventive monitoring method and/or with the inventive monitoring device can for example be an abnormal field intensity. High frequency (in particular more than 1 kHz, preferably a few kHz) changes of the magnetic field strength can also be detected or interpreted as anomalies.

Alternatively or in addition magnetic field values above normal load conditions, for example caused by fault currents, can be detected or interpreted as magnetic field anomalies.

Also, deviations between load currents of the at least one coil and values measured with the magnetic field sensor and/or values deduced therefrom can be determined. In this case it is further preferred that deviations of more than a predetermined value are interpreted as magnetic field anomalies.

In preferred embodiment the monitoring system according to the invention is embodied and/or configured to recognize/detect a magnetic field anomaly and by that a winding fault in one or more of the aforementioned cases.

For determining if an anomaly is present, a comparison of at least one value measured with the magnetic field sensor (and/or at least one value deduced from the at least one measured value) with at least one reference value is carried out. The at least one reference value can for example be a value which was measured before under known conditions without any winding faults, for example at the electrical device to be monitored or at another, expediently identically or at least similarly constructed electrical device. With other words, a reference measurement is or was performed. One or more reference values can be or have been recorded, for example, immediately after commissioning of the electrical device to be monitored or of an identical or similar electrical device, when the isolation between the windings of the coil(s) is or was expected to be in perfect condition.

Only one reference value or several reference values can be used. A number of reference values can for example be given by several reference values recorded one after the other in time. It can be a sequence of measured values recorded in a certain period of time, e.g. after commissioning. For example, the temporal course of the magnetic field without winding faults can be recorded and the corresponding measurement can be used as a reference for the comparison for determining anomalies and by that winding short circuits.

The at least one reference value can also be given by a so called "fingerprint" in particular of the magnetic field.

It is also possible to use at least one value deduced from the at least one value measure with the magnetic field sensor for the purposes of the comparison. A deduced value can for example be obtained or have been obtained by further processing the measured value(s). In other words, the comparison must not be based (directly) on the data obtained from the magnetic field sensor but also values derived therefrom can be considered.

In an especially preferred embodiment a magnetic field sensor is used which can measure static magnetic fields, or in other words magnetic DC fields. The at least one magnetic field sensor of the inventive monitoring device can accordingly be embodied for measuring static magnetic fields. In particular a magnetic field sensor is used which comprises or consist of at least one preferably linear Hall sensor.

A Hall sensor is to be understood in particular as a sensor or element that uses the Hall effect for magnetic field detection. Hall sensors are sometimes also referred to as Hall effect sensors and expediently are semiconductor components.

The method according to the invention can furthermore comprise that the magnetic field sensor is arranged on the electrical device. In particular, it may be arranged in a front end or face side region and/or inside the or at least one coil. The magnetic field sensor may be attached to a support arrangement for the at least one coil, in particular to a support star for the at least coil, which has been found to be especially suitable.

If a monitoring device according to the invention is used, it can be arranged at a corresponding position on the electrical device. In an advantageous embodiment, the monitoring device according to the invention has fastening means for fastening it to an electrical device, in particular to a support arrangement of at least one coil of an electrical device.

The electrical device which is monitored with the method according to the invention and/or by means of the monitoring device according to the invention may be, for example, an air core reactor. Then, the magnetic field sensor or monitoring device is preferably arranged in the area of the air core and/or at or near the, in particular, upper end face of at least one coil of the air core reactor. Air core reactors are usually used to compensate for capacitive reactive power and are also referred to as air core shunt reactors.

While the method and monitoring device according to the present invention have proven particularly suitable for monitoring air core reactors for winding faults, they can, of course, also be used for reliably monitoring other electrical devices for winding faults of their coil(s). Oil- or gas-insulated reactors or oil- or gas-insulated transformers can be mentioned as examples in this regard.

The electrical device to be monitored may comprise only one or more coils and only one or more coils of an electrical device may be monitored for winding short circuits. An air core reactor for example may comprise a coil array with two or more coils which preferably are hollow-cylindrical and arranged coaxially.

In a preferred embodiment, the monitoring device according to the invention has signal processing properties. In particular, it is provided that the processing unit is embodied and/or configured to preprocess or further process measured values or measured data acquired by means of the at least one magnetic field sensor.

The processing unit can comprise or consist of at least one microcontroller or at least one microcontroller-based sensor node.

The processing unit can be embodied and/or configured to subject the measured values or measured data acquired with the at least one magnetic field sensor to a Fourier transformation, in particular a fast Fourier transformation (FFT) and/or at least one filtering process.

A further embodiment of the monitoring device according to the invention is characterized in that the power supply unit is embodied such that it can provide electrical energy for supplying the magnetic field measuring unit and the processing unit and the data transfer unit when it is exposed to at least one magnetic field. In other words, the electrical energy for feeding the components or units of the monitoring device according to the invention can be provided via the magnetic field or obtained from the magnetic field, which is measured with the at least one magnetic field sensor for detecting winding faults. A separate energy source or a wired connection for energy supply are not necessary then. The monitoring device according to the invention is energy "self-sufficient" in this case.

For example, the power supply unit may comprise or consist of at least one energy harvester. Energy harvesting in particular means the extraction of small amounts of electrical energy from the environment, e.g. the ambient temperature, vibrations, air movements or the like. Energy harvesting offers the advantage of not needing a wired power supply or batteries.

Magnetic fields can also be used for energy harvesting, which is the case in a preferred embodiment of the invention. The at least one energy harvester accordingly can be embodied to provide an electrical voltage when exposed to a magnetic field. Energy self-sufficiency is provided by the at least one energy harvester and from the magnetic field to be monitored in this case.

Another embodiment is characterized in that the monitoring device comprises a housing and the magnetic field measuring unit, the processing unit, the data transfer unit and the power supply unit are arranged within the housing. The four units preferably completely extend within the housing. In a further preferred embodiment, the four units are encapsulated by the housing.

The invention also relates to the use of an inventive monitoring device for monitoring an electrical device comprising at least one coil, in particular a reactor, preferably an air core reactor, or a transformer, for winding short circuits.

Furthermore, the invention relates to an arrangement comprising an electrical device with at least one coil, in particular a reactor, preferably an air core reactor, or a transformer, and at least one monitoring device according to the invention. The monitoring device can be attached to the electrical device.

With regard to the embodiment of the invention, reference is also made to the subclaims and to the following description of an embodiment with reference to the attached drawing. The drawing shows as follows:
- Figure 1: a purely schematic perspective view of an arrangement comprising an electrical device, namely an air core reactor, and an embodiment of a monitoring device according to the invention being attached thereto;
- Figure 2: a purely schematic view showing windings of a coil and a winding fault;
- Figure 3: an enlarged purely schematic representation of the monitoring device of figure 2.

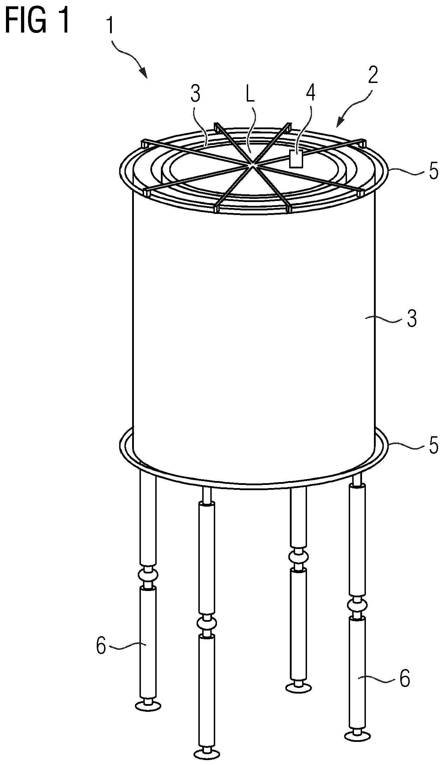

Figure 1 shows a schematic perspective view of an embodiment of an arrangement 1 according to the invention comprising an electrical device 2 with at least one coil 3 and a monitoring device 4 attached to the electrical device 2.

The electrical device is embodied as an air core reactor 2. This is to be understood exemplary. Further examples for electrical devices with at least one coil 3 are oil- or gas-insulated reactors or transformers, which can also be oil or gas-insulated.

The air core reactor 2 comprises several, for example three coils 3, namley an inner, an outer and a middle coil 3 extending between the inner and outer coil 3. Each coil 3 is hollow-cylindrical and the coils are arranged coaxially. The coils 3 form a coil arrangement which itself is of hollow-cylindrical form. The central axis is oriented vertically. It is emphasized that the number of three coils 3 is to be understood purely exemplary and that the air core reactor 2 - or another electrical device - may also comprise only one or two or more than three coils 3.

Inside the hollow-cylindrical coil array there is air. One can also say the air core reactor 2 comprises an air core L.

The air core reactor 2 further comprises two support arrangements for the coils 3, namely an upper and a lower support star 5. The monitoring device 4 is attached to the upper support star 5, whereby it is disposed at a point above the air core L on the support star 5. Four elongated legs 6 protrude from the lower support star 5, via which the electrical device 2 is supported on and insulated against the ground.

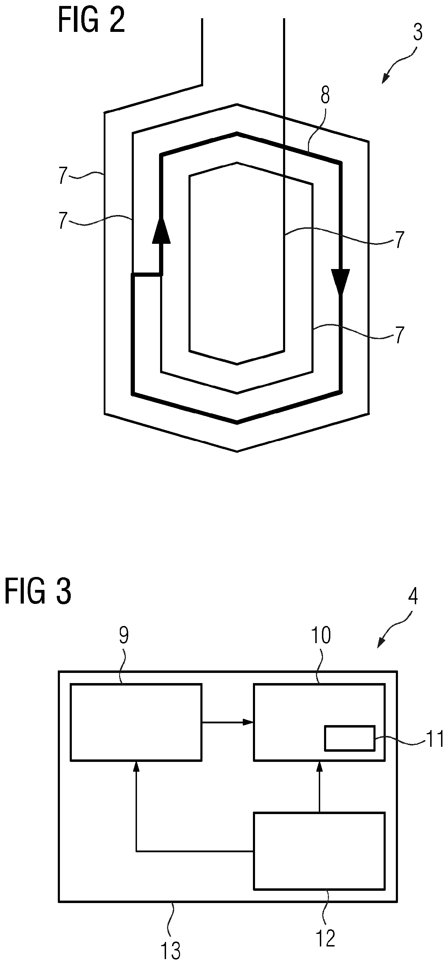

Each of the coils 3 comprises several windings 7 in a manner known per se. Figure 2 shows - purely schematically - a sectional view through a coil 3 with windings 7. The windings 7 are separated from each other by an insulating material, in other words an insulation (not shown in the highly simplified figure 2). The insulation can be damaged so that winding short circuits, in particular short circuits between adjacent windings 7, can occur. Such a winding short circuit 8 is schematically indicated in figure 2 by a closed circle with thicker line - here between the two inner windings 7.

A high risk is associated with turn-to-turn winding faults 8. If they occur, they can for example lead to smoldering fires in the insulation, so that the air core reactor 2 can catch fire and burn down.

The monitoring device 4 can be used for detecting winding short circuits 8 as early as possible.

As shown in the enlarged view of figure 3, the monitoring device 4 comprises a magnetic field measuring unit 9, which comprises or consists of at least one magnetic field sensor. In the shown example, the magnetic field measuring unit consist of a linear Hall sensor 9. The Hall sensor 9 is a semiconductor device which can be used to measure magnetic fields, including magnetic DC fields, using the Hall effect.

The monitoring device 4 and by that the comprised Hall sensor 9 is, as mentioned above, attached to the upper support star 5 above the air core L so that the Hall sensor 9 is exposed to the magnetic field generated by the coils 3 of the air core reactor 2 during operation and can measure the magnetic field. For example, model MLX91207 by Melexis may be used as a Hall sensor.

The monitoring device 4 also comprises a processing unit 10 being connected to the magnetic field measuring unit 9 and being able to receive and process data that has been acquired with the magnetic field measuring unit 9. Here the processing unit 10 consits of a micro controller or a micro controller based sensor nod, in particular consisting of a micro controller and sensors on SPI bus or I2C bus or another suitable bus.

The monitoring device 4 furthermore comprises a data transfer unit 11 being connected to the processing unit 10 and being embodied for wirelessly transmitting data. While in figure 3 the data transfer unit 11 is shown as being part of the processing unit 10, this is to be understood purely as an example. The data transfer unit 11 in principle can also be embodied separate from the processing unit 10.

The monitoring device 4 also comprises a power supply unit 12 for electrical supply of the magnetic field measuring unit 9, the processing unit 10 and the data transfer unit 11. In the shown example, the power supply unit 12 comprises or consist of an energy harvester so that the monitoring device 4 is energy self-sufficient and does not require cabled power supply. The energy harvester 12 is embodied and/or configured such that it obtains/extracts the electrical energy required for supplying the said units 9, 10, 11 from the magnetic field that is generated by the coils 3 during operation of the air core reactor 2. In other words, the energy self-supply of the monitoring device 4 comes from the magnetic field. The energy harvester 12 expediently is embodied and/or configured to provide an electrical voltage when it is exposed to a magnetic field.

The magnetic field sensor 9, the processing unit 10, the data transfer unit 11 and the power supply unit 12 are arranged in a common housing 13 of the monitoring device 4, which protects them from environmental influences. The housing 13 can be completely closed, since neither data transmission nor power supply ports are required.

The monitoring device 4 can be used to carry out an exemplary embodiment of the method according to the invention as described below.

During operation of the electrical device 2, the magnetic field generated by the coils 3 is measured continuously or at predetermined times with the magnetic field measuring unit 9.

Purely by way of example, a measured value may be recorded every second or every few, say every two or three or more seconds.

The measured values are used to determine whether an anomaly of the magnetic field is present.

A comparison of at least one value measured with the magnetic field sensor 9 and/or at least one value deduced therefrom with at least one reference value is carried out. The processing unit 10 is embodied and/or configured accordingly. The at least one reference value is stored in the processing unit 10.

The at least one reference value can for example be a value which was measured before under known conditions without any winding faults 8, for example at the electrical device 2 to be monitored or at another, expediently identically or at least similarly constructed electrical device. In other words, a reference measurement is/was performed. One or more reference values can be or have been recorded, for example, immediately after commissioning of the electrical device 2 to be monitored or of an identical or similar electrical device, when the isolation between the windings 7 of the coil(s) 3 is or was expected to be in perfect condition.

In the shown example, a "fingerprint" of the magnetic field representing a normal operation without winding faults 8 is stored as reference in the processing unit 10.

The evaluation preferably essentially consists of a comparison between the measurement data and the reference data or values, in particular "fingerprint", with regard to the load current, to issue messages or (warn) signals in case of deviations in the correlation. The processing unit 10 can be embodied and/or configured accordingly.

The presence of an anomaly of the magnetic field is used to identify an impending or occurred winding short circuit 8. In other words, it is assumed that a winding short circuit 8 is impending or occurred when an anomaly of the magnetic field has been detected.

A magnetic field anomaly due to which a winding short circuit 8 is detected in the framework of the inventive method and/or with the inventive monitoring device 4 can for example be an abnormal field intensity which does not correlate with the current through the coil(s) 3. High frequency (in particular more than 1 kHz, preferably a few kHz) changes of the magnetic field strength can also be detected or interpreted as anomalies. Such a change can be caused, for example, by an intermittent winding short circuit 8. Alternatively or additionally, magnetic field values above normal load conditions can be interpreted as magnetic field anomalies and used as warnings for system disturbances.

Due to magnetic field monitoring a very high sensitivity is obtained and winding short circuits 8 can be detected quite reliably also at an early stage of developing failures. Preventive detection before the occurrence of major damage, like smoldering fires or the like, becomes possible. Since a very early (preventive) and particularly reliable detection is possible, the number of faults can be reduced and costs saved. The insulation of the coils 3 can be better protected.

The data transfer unit 11 is embodied and/or configured to send a signal, in particular warning signal wirelessly to a ground station located at a distance from the electrical device 2 in case a magnetic field anomaly is detected. Such a ground station can be an IoT device (not shown in the figures).

The ground station can then for example send a warning signal or message to a user. Alternatively or in addition a switching event can be triggered preferably automatically in case an anomaly is detected. The electrical device can also automatically be switched off.

Since the data transmission from the monitoring device to the ground station is wireless, the coil(s) 3 insulation is not compromised.

Although the present invention has been described in detail with reference to the preferred embodiment, it is to be understood that the present invention is not limited by the disclosed examples, and that numerous additional modifications and variations could be made thereto by a person skilled in the art without departing from the scope of the invention.

Regardless of the grammatical gender of a particular term, persons with male, female, or other gender identity are included.

### List of Refernce Signs

- 1: arrangement
- 2: electrical device
- 3: coil
- 4: monitoring device
- 5: support structure
- 6: leg
- 7: winding
- 8: winding short circuit
- 9: magnetif field ,easuring unit
- 10: processing unit
- 11: data transfer unit
- 12: power supply unit
- 13: housing
- L: air core

## Claims

1. Method for monitoring an electrical device (2) comprising at least one coil (3), in particular a reactor, preferably an air core reactor, or a transformer, for winding short circuits (8), in which
- during operation of the electrical device (2) a magnetic field generated by the at least one coil (3) is continuously or at predetermined times measured with a magnetic field sensor (9),
- it is determined if an anomaly of the magnetic field, in particular an abnormal field intensity, is present, wherein a comparison of at least one value measured with the magnetic field sensor (9) and/or at least one value deduced therefrom with at least one reference value is carried out, and
- the presence of an anomaly of the magnetic field is used to identify an impending or occurred winding short circuit (8).

2. Method according to claim 1,
**characterized in that**
high frequency changes of the magnetic field strength and/or magnetic field values above normal load conditions are interpreted as magnetic field anomalies.

3. Method according to claim 1 or 2,
**characterized in that**
deviations between load currents of the at least one coil (3) and values measured with the magnetic field sensor (9) and/or values deduced therefrom are determined, preferably, wherein deviations of more than a predetermined value are interpreted as magnetic field anomalies.

4. Method according to any of the preceding claims,
**characterized in that**
a magnetic field sensor (9) is used which can measure static magnetic fields, preferably a magnetic field sensor (9) which comprises or consist of at least one preferably linear Hall sensor.

5. Method according to any of the preceding claims,
**characterized in that**
the magnetic field sensor (9) is arranged on the electrical device (2), preferably in a face side region and/or inside the or at least one coil (3), and/or **in that** the magnetic field sensor (9) is attached to a support arrangement for the at least one coil (3), in particular at a support star (5) for the at least one coil (3).

6. Method according to claim 5,
**characterized in that**
the electrical device (2) is an air core reactor and the magnetic field sensor (9) is disposed in the area of the air core (L) and/or at or near the, in particular, upper end face of at least one coil (3) of the air core reactor (2).

7. Monitoring device (4) for monitoring an electrical device (2) comprising at least one coil (3), in particular a reactor, preferably an air core reactor, or a transformer, for winding short circuits, comprising
- a magnetic field measuring unit (9) comprising or consisting of at least one magnetic field sensor, in particular at least one preferably linear Hall sensor,
- a processing unit (10) being connected to the magnetic field measuring unit (9) and being able to receive and process data that has been acquired with the magnetic field measuring unit (9),
- a data transfer unit (11) being connected to the processing unit (10) and being embodied for wirelessly transmitting data,
- a power supply unit (12) for electrical supply of the magnetic field measuring unit (9) and the processing unit (10) and the data transfer unit (11).

8. Monitoring device (4) according to claim 7,
**characterized in that**
the processing unit (10) is embodied and/or configured to determine if an anomaly of a magnetic field being measured with the magnetic field sensor (9), in particular an abnormal field intensity, is present, preferably by comparison of at least one value measured with the magnetic field sensor (9) and/or at least one value deduced therefrom with at least one reference value which preferably is stored in the processing unit (10), in particular, wherein the data transfer unit (11) is embodied and/or configured to wirelessly send a signal if a magnetic field anomaly is present.

9. Monitoring device (4) according to claim 7 or 8,
**characterized in that**
the magentic field sensor (9) is embodied to measure static magnetic fields.

10. Monitoring device (4) according to any of claims 7 to 9,
**characterized in that**
the power supply unit (12) is embodied such that it can provide electrical energy for supplying the magnetic field measuring unit (9) and the processing unit (10) and the data transfer unit (11) when it is exposed to at least one magnetic field.

11. Monitoring device (4) according to any of claims 7 to 10,
**characterized in that**
power supply unit (12) comprises or consists of at least one energy harvester, preferably, wherein the at least one energy harvester is embodied to provide an electrical voltage when exposed to a magnetic field.

12. Monitoring device (4) according to any of claims 7 to 11,
**characterized in that**
the monitoring device (4) comprises a housing (13) and the magnetic field measuring unit (9), the processing unit (10), the data transfer unit (11) and the power supply unit (12) are arranged within the housing (13).

13. Use of a monitoring device according to any of claims 7 to 12 for monitoring an electrical device (2) comprising at least one coil (3), in particular a reactor, preferably an air core reactor, or a transformer, for winding short circuits (8).

14. Arrangement (1) comprising an electrical device (2) comprising at least one coil (3), in particular a reactor, preferably an air core reactor, or a transformer, and at least one monitoring device (4) according to any of claims 7 to 12.
